# EUROPEAN PATENT APPLICATION

(11) **EP 4 160 710 A1**
(43) Date of publication of application: **05.04.2023**
(21) Application number: 21812084.8
(22) Date of filing: 25.05.2021
(51) Int. Cl.: H01L 51/44

(54) **CORE-SHELL PARTICLE, COMPOSITE, LIGHT-RECEIVING MEMBER FOR PHOTOELECTRIC CONVERSION ELEMENT, AND PHOTOELECTRIC CONVERSION ELEMENT**

(30) Priority: 28.05.2020 JP 2020093726
(71) Applicant: Japan Science and Technology Agency, Kawaguchi-shi, Saitama 332-0012 (JP)
(72) Inventor: NIHEI, Ayumi, Yokohama-shi, Kanagawa 225-8503 (JP); MIYASAKA, Tsutomu, Yokohama-shi, Kanagawa 225-8503 (JP)
(74) Representative: Gilani, Anwar
(86) International application number: PCT/JP2021/019717
(87) International publication number: WO 2021/241542

(57) **Abstract**

A core-shell particle which includes a core-shell structure includes an inorganic nanoparticle having a light wavelength conversion ability and a coating layer formed on a surface of the inorganic nanoparticle and formed of an inorganic perovskite type substance.

## Description

### [Technical Field]

The present invention relates to a core-shell particle, a composite, a light-receiving member for a photoelectric conversion element, and a photoelectric conversion element. Priority is claimed on Japanese Patent Application No. 2020-093726, filed May 28, 2020, the content of which is incorporated herein by reference.

### [Background Art]

Photoelectric conversion elements such as solar cells and photodiodes are widely used in various fields. However, conventional photoelectric conversion elements have a problem that detection sensitivity is weaker for light in a near infrared range than light in a visible light range. If the detection sensitivity for light in a near infrared range can be increased as in the case of visible light, for example, in solar cells, the photoelectric conversion efficiency can be improved.

Patent Literature 1 discloses a technique using up-conversion nanoparticles as an inorganic porous material for supporting an organic-inorganic composite perovskite type compound which is a power generation layer. Here, the up-conversion nanoparticles have a function of converting long-wavelength light such as infrared light into short-wavelength light such as visible light and ultraviolet light, and having a particle size of nm order. In this technique, long-wavelength light such as near infrared light absorbed by inorganic core-shell particles is converted into short-wavelength light such as visible light and ultraviolet light, the converted light is re-absorbed into organic-inorganic composite perovskite crystals, energy is excited, and an electromotive force is generated.

Non Patent Literature 1 discloses a technique using an up-conversion function of inorganic nanoparticles when inorganic nanoparticles (Lanthanide-doped NPS) and inorganic perovskite quantum dots (CaPbX₃(X=Cl, Br, I)PeQDs) are separated from each other and mixed. In this technique, visible light generated by near infrared light excitation by inorganic nanoparticles is re-absorbed by inorganic perovskite quantum dots and light is emitted.

### [Citation List]

### [Patent Literature]

[Patent Literature 1]
Japanese Unexamined Patent Application, First Publication No. 2015-92563

### [Non Patent Literature]

[Non Patent Literature 1]
Wei Zheng et al., Nature Communications (2018) 9:3462

### [Summary of Invention]

### [Technical Problem]

In the configuration disclosed in the above literature, since energy loss is unavoidable when light after wavelength conversion is re-absorbed by perovskites, when light to be absorbed is weak, it is difficult to generate a sufficient electromotive force or light emission.

In conventional up-conversion nanoparticles containing rare earth ions, the concentration of ions responsible for light emission needs to be about 1 to 5%, and when the concentration of ions responsible for light emission is high, light emission disappears. This is because cross relaxation occurs between luminescent species under high concentration conditions, and energy is deactivated by thermal vibration of chain organic molecules coated on the surface of nanoparticles. Therefore, the amount of light absorption is very small and up-conversion does not occur unless light is strong.

The present invention has been made in view of the above circumstances, and an object of the present invention is to make it possible to obtain excellent visible light sensitization characteristics using weak light having a long wavelength.

### [Solution to Problem]

In order to achieve the above object, the present invention provides a core-shell particle, a composite, a light-receiving member for a photoelectric conversion element, and a photoelectric conversion element. Here, the present invention includes the following aspects.
(1) A core-shell particle which includes a core-shell structure according to one aspect of the present invention includes an inorganic nanoparticle having a light wavelength conversion ability, and a coating layer that is formed on a surface of the inorganic nanoparticle and formed of an inorganic perovskite type substance.
(2) In the core-shell particle according to (1), preferably, the inorganic nanoparticle includes a rare earth element.
(3) A composite according to one aspect of the present invention is an aggregate or a thin film including a perovskite structure as a main component, and additionally included the core-shell particle according to (1) or (2).
(4) A light-receiving member for a photoelectric conversion element according to one aspect of the present invention includes a layer composed of the composite according to (3) and a layer composed of an aggregate or a thin film including an organic or an inorganic semiconductor (including a metal complex) as a main component that are laminated.
(5) A photoelectric conversion element according to one aspect of the present invention includes the light-receiving member for a photoelectric conversion element according to (4) between a hole transport layer and an electron transport layer.
(6) A photoelectric conversion element according to one aspect of the present invention includes a first layer, a second layer and a third layer that are laminated in that order, in which the first layer is composed of a plurality of particles including an inorganic semiconductor as a main component, or an aggregate thereof or a thin film including the inorganic semiconductor as a main component, the second layer is formed on a surface of the first layer and is composed of the composite according to claim 3, and the third layer is composed of a plurality of particles including an organic or an inorganic semiconductor (including a metal complex) as a main component, or an aggregate thereof or a thin film including the organic or the inorganic semiconductor (including a metal complex) as a main component, and in a conduction band, an energy level of the second layer is higher than an energy level of the first layer, and an energy level of the third layer is higher than the energy level of the second layer.
(7) In the photoelectric conversion element according to (6), the third layer includes an organic metal complex as a main component, and the energy level of the second layer band may be higher than the energy level of the third layer in a valence.

### [Advantageous Effects of Invention]

According to the present invention, the dopant concentration of a luminescent species, which was several % in the related art, can be increased to 100% by forming a perovskite coating layer on the surface. Thereby, it is possible to obtain excellent visible light sensitization characteristics using weak light having a long wavelength.

According to the present invention, it is possible to provide a core-shell particle, a composite, a light-receiving member for a photoelectric conversion element, and a photoelectric conversion element using which it is possible to obtain high visible light sensitization characteristics using weak light having a long wavelength.

### [Brief Description of Drawings]

Fig. 1 shows cross-sectional views of a core-shell particle according to one embodiment of the present invention.
Fig. 2 shows cross-sectional views of a photoelectric conversion element including the core-shell particle in Fig. 1.
Fig. 3 shows structures of energy bands of respective layers during an operation of the photoelectric conversion element in Fig. 2.
Fig. 4 shows cross-sectional views of modified examples of a photoelectric conversion element including the core-shell particle in Fig. 1.
Fig. 5 shows structures of energy bands of respective layers during an operation of the photoelectric conversion element in Fig. 4.
Fig. 6 shows cross-sectional views of an object to be processed in a process of producing the photoelectric conversion element in Fig. 2.
Fig. 7 is a graph showing light emission spectrums of core-shell particles 1 and 2 and nanoparticles 1.
Fig. 8 is a graph showing changes in an absorption rate due to a difference in a structure of core-shell particles in a second layer.
Fig. 9 shows an SEM image of a cross section of a photoelectric conversion element produced as Example 2.
Fig. 10 is a graph showing a spectrum of light emission generated after light whose wavelength is converted by a second layer of a photoelectric conversion element of Example 2 is absorbed.
Fig. 11 is a graph showing a response speed of a photocurrent obtained in the photoelectric conversion element.

### [Description of Embodiments]

Hereinafter, a core-shell particle, a composite, a light-receiving member for a photoelectric conversion element, and a photoelectric conversion element according to embodiments to which the present invention is applied will be described in detail with reference to the drawings. Here, in the drawings used in the following description, in order to facilitate understanding of features, featured parts are enlarged for convenience of illustration in some cases, and dimensional ratios of components are not necessarily the same as actual ones. In addition, materials, sizes, and the like exemplified in the following description are examples, and the present invention is not limited thereto, and can be realized by appropriate modifications thereof without departing from the gist of the invention.

### (Core-shell particles)

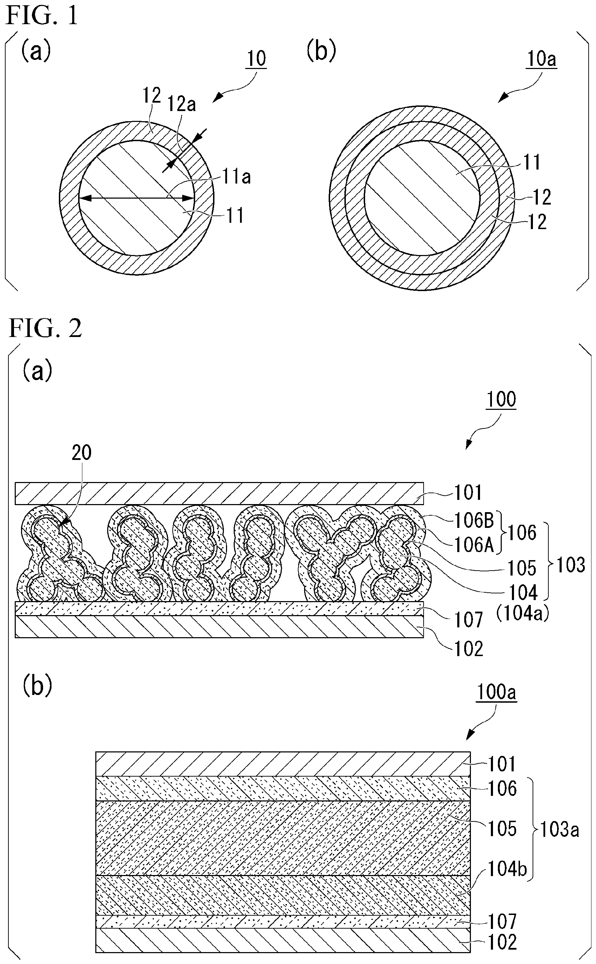

Fig. 1 shows cross-sectional views schematically showing a configuration of a core-shell particle 10 according to one embodiment of the present invention. The core-shell particle 10 mainly includes an inorganic nanoparticle 11 and a coating layer 12 thereof, and has a core-shell structure.

The inorganic nanoparticle 11 is a particle having a particle size (diameter) 11a of about 10 nm to 100 nm, and has a light wavelength conversion ability. The light wavelength conversion ability here means an ability to convert a wavelength of incident light and emit light having a wavelength different from that of incident light. In the present embodiment, a case in which incident near infrared light whose wavelength is converted is emitted as visible light will be described as an example.

Examples of main materials of the inorganic nanoparticle 11 include rare earth elements such as erbium (Er), thulium (Tm), ytterbium (Yb), neodymium (Nd), holmium (Ho), praseodymium (Pr), gadolinium (Gd), europium (Eu), terbium (Tb), samarium (Sm), and cerium (Ce) or something containing at least one compound thereof.

The coating layer 12 is formed on the surface of the inorganic nanoparticle 11 and is formed of an inorganic perovskite type substance. Since the surface of up-conversion nanoparticles of a general rare earth element is coated with a plurality of chain organic molecules (oleylamine, oleic acid, etc.), dispersion of light emission occurs through thermal vibration of chain organic molecules. On the other hand, in the core-shell particle 10 of the present disclosure, since the coating layer 12 covers the surface of the inorganic nanoparticle 11, unlike general up-conversion nanoparticles, there is no thermal vibration of chain organic substances (organic ligand), and it is possible to minimize dispersion of light emission through thermal vibration. The coverage of the coating layer 12 on the surface of the inorganic nanoparticle 11 may be approximately 50% or more and is preferably 100%.

The thickness 12a of the coating layer 12 may be 5% or more of the particle size 11a of the inorganic nanoparticles, and is preferably substantially uniform over the surface of the inorganic nanoparticles. When the thickness 12a of the coating layer 12 is thicker, the photoelectric conversion efficiency is improved.

Examples of materials of inorganic perovskite type substances constituting the coating layer 12 include a composite composed of three types of inorganic elements, for example, CsPbX₃ (X=CT, Br⁻, I⁻) and the like. X includes at least one of halogen ions. For example, when ErYF₄ or Er, Yb-doped NaYF₄ (NaYF4: Er, Yb) is used as the inorganic nanoparticle 11, it is preferable to use CsPbBrs or CsPbI₃ so that the photoelectric conversion efficiency is improved. When Tm, Yb-doped NaYF₄ (NaYF4: Tm, Yb) is used, it is preferable to use CsPbCl₃ so that the photoelectric conversion efficiency is improved.

Fig. 1(b) shows a modified example of the core-shell particle 10 shown in Fig. 1(a). As shown in Fig. 1(b), the coating layer 12 may be formed by overlapping two layers or may be formed by three or more layers.

### (Photoelectric conversion element)

Fig. 2(a) is a cross-sectional view of a photoelectric conversion element 100 including the core-shell particle 10. The photoelectric conversion element 100 is mainly composed of a positive electrode layer (positive electrode member) 101, a negative electrode layer (negative electrode member) 102, and a photoelectric conversion layer 103 interposed therebetween.

A buffer layer 107 may be interposed between the negative electrode layer 102 and the photoelectric conversion layer 103, in which E_{cb} as an energy level in a conduction band is present between E_{c2} and E_{c3} as energy levels of the negative electrode layer 102 and the photoelectric conversion layer 103 in the conduction band (that is, E_{c2}<E_{cb}<E_{c3}). Examples of materials constituting the buffer layer 107 include europium oxide (Eu₂O₃), titanium oxide, and tin oxide.

In order to allow the photoelectric conversion layer 103 to receive light, the negative electrode layer 102 may be formed of a material having light transmitting properties, for example, antimony-doped indium oxide (ATO), indium tin oxide (ITO), zinc oxide, tin oxide, or fluorine-doped indium oxide (FTO). In the process of producing the photoelectric conversion layer 103 of the present embodiment, it is necessary to perform a heat treatment. Therefore, as the material of the negative electrode layer 102, ATO having heat resistance is preferable among the above materials.

The positive electrode layer 101 does not have to be transparent, and a metal, a conductive polymer or the like can be used as the electrode material of the electrode. Specific examples of electrode materials include metals such as gold (Au), silver (Ag), aluminum (Al), and zinc (Zn), an alloy of two or more among the metals, graphite, graphite interlayer compounds, polyanilines and derivatives thereof, polythiophene and derivatives thereof. Examples of materials of the transparent positive electrode layer 101 include ITO.

As shown in Fig. 2(a), mainly, the photoelectric conversion layer 103 may be a laminate including a first layer 104a composed of a plurality of particles 20 including an inorganic semiconductor as a main component (hereinafter referred to as "inorganic semiconductor particles"), a second layer 105 which is formed on the surface of the first layer 104a, and is composed of an aggregate or a thin film (composite) including a perovskite structure as a main component, and additionally including the core-shell particle 10, and a third layer 106 composed of a plurality of particles including an organic or an inorganic semiconductor (including a metal complex) as a main component or an aggregate thereof, or a thin film including the organic or the inorganic semiconductor (including a metal complex) as a main component. That is, the photoelectric conversion element 100 may have a configuration in which the positive electrode layer 101, the third layer 106, the second layer 105, the first layer 104, and the negative electrode layer 102 are arranged in that order, and at least a current path is formed from the positive electrode layer 101 to the negative electrode layer 102. Here, "including an inorganic semiconductor as a main component" means that, in inorganic semiconductor particles 20, the inorganic semiconductor is contained in an amount in which functions of the present invention can be exhibited, and specifically, for example, the content of the inorganic semiconductor is more than 50 volume%. The content is preferably more than 90 volume%, and more preferably, the main component is composed of a substantially inorganic semiconductor. "Including a perovskite structure as a main component" means that the perovskite structure is contained in an amount in which functions of the present invention can be exhibited with respect to a total mass of the second layer 105, and specifically, for example, the content of the perovskite structure is more than 50 volume%. The content is preferably 70 volume% or more. In addition, "including an organic or an inorganic semiconductor (including a metal complex) as a main component" means that the aggregate or thin film (composite) containing the core-shell particle 10 is contained in an amount in which functions of the present invention can be exhibited with respect to a total mass of the third layer 106, and specifically, for example, the content of the aggregate or thin film (composite) containing the core-shell particle 10 is more than 50 mass%. The content is preferably more than 90 volume%, and more preferably, the main component is composed of a substantially organic or inorganic semiconductor (including a metal complex). A larger number of current paths to be formed is more preferable, but adjacent current paths may or may not be electrically connected to each other. Here, in the present embodiment, "layer" refers to a film that is formed by performing a film formation process once or multiple times, and the film is not limited to being flat and is not necessarily an integrated film.

In addition, materials and compositions of the three layers 104 to 106 are determined such that energy levels in the conduction band (LUMO, excited state) increase in order of the first layer 104, the second layer 105, and the third layer 106. For example, in the first layer 104, the energy level in the valence band can be set to -8 eV or higher, and the energy level in the conduction band can be set to -4 eV or lower. In this case, in the second layer 105, the energy level in the valence band can be set to - 6.0 eV or higher, and the energy level in the conduction band can be set to -3 eV or lower. In addition, in the third layer 106, the energy level in the conduction band is preferably -2 eV or lower.

The first layer 104a is an aggregate of a plurality of inorganic semiconductor particles 20 formed on the negative electrode layer 102 and is a porous film including a plurality of voids between the inorganic semiconductor particles 20. The inorganic semiconductor particle 20 in contact with the second layer 105 comes into direct contact with the negative electrode layer 102 or comes into indirect contact with the negative electrode layer 102 via another inorganic semiconductor particle 20 so that it is electrically connected to the negative electrode layer 102.

As the inorganic semiconductor contained in the inorganic semiconductor particle 20, one having an absorption wavelength in the ultraviolet light range is preferable, and examples thereof include titanium oxide and zinc oxide. The thickness of the first layer 104 is preferably about 10 nm or more and 1,000 nm or less and more preferably about 50 nm or more and 500 nm or less.

In the production step, the second layer 105 is a thin film that covers an exposed portion on the surface of the inorganic semiconductor particle 20, that is, a portion that is not in contact with the negative electrode layer 102 and the inorganic semiconductor particle 20. The second layer 105 does not need to cover the entire exposed portion, but should cover at least the side of the positive electrode layer 101 in order to form the current path.

The perovskite structure constituting the second layer 105 is composed of a plurality of molecules including metal cations such as Pb²⁺ and Sn²⁺, halogen anions such as I⁻, Cl⁻, and Br-, and organic cations such as CH₃NH₃⁺ (MA), NH=CHNH₂⁺ (FA), and Cₛ⁺. The size and shape of the band gap can be changed depending on the number of ions selected from among metal cations, halide anions, and organic cations. When tin is added to the perovskite structure, the band gap is narrowed, the responsiveness to long-wavelength light such as near infrared light can be improved, but oxidation easily occurs in the atmosphere and characteristics deteriorate. For respective molecules constituting the perovskite structure, the halogen anion is disposed at a vertex of a regular octahedron around a metal ion, and the organic cation is disposed in the vicinity of a cube containing a regular octahedron, centered on metal ions. Specifically, a regular octahedron formed of metal ions and halogen anions forms a three-dimensional lattice, and organic cations enter gaps thereof in the structure.

When the core-shell particle 10 forms the second layer 105 while in contact with the perovskite structure, the boundary between the coating layer 12 and the perovskite structure in the core-shell particle 10 disappears. Therefore, light converted into visible light in the core-shell particle 10 is efficiently absorbed by the perovskite structure including the coating layer 12. Accordingly, it is possible to improve the detection sensitivity of light in the near infrared range of the photoelectric conversion element 100.

When a proportion of the core-shell particle 10 in the second layer 105 is 5 wt% or more, this is preferable so that the sensitivity of light in a near infrared range is improved. When the proportion ratio of the core-shell particle 10 in the second layer 105 is more than 30 wt%, it is difficult to form a perovskite structure, and therefore 30 wt% or less is preferable.

In addition, preferably, the energy level of the valence band of the second layer 105 is lower than the energy level of the valence band of the third layer 106 and is intermittently connected to the same energy level. Examples of the composition of the second layer 105 (perovskite structure) satisfying these conditions include CH₃NH₃Pbl₃, NH=CHNH₂PbI₃, and CsPbI₃. In addition, examples thereof include those in which a composition ratio of I and Cl or Br among halide anions is changed.

The third layer 106 may be a thin film that covers a surface (exposed surface) of the perovskite structure contained in the second layer within a photoelectric conversion element precursor including the first layer 104 and the second layer 105. The third layer 106 is formed of any of a p-type organic semiconductor, an inorganic semiconductor, and an organic metal complex. Fig. 2(a) shows an example of an organic metal complex, and in Fig. 2(a), 106A indicates an inorganic transition metal ion of the third layer 106, and 106B indicates an organic ligand of the third layer 106. The thickness of the third layer 106 is preferably, for example, 1 nm or more and 100 nm or less.

Examples of p-type organic semiconductors constituting the third layer include bathocuproine (BCP), 2,2',7,7'-tetrakis(N,N'-di-p-methoxyphenylamine)-9,9'-spirobifluorene (Spiro-OMeTAD), poly(3,4-ethylenedioxythiophene):poly(styrenesulfonate) (PEDOT:PSS), and N,N,N',N'-tetrakis(4-methoxyphenyl)-benzidine (TPD).

Examples of p-type inorganic semiconductors constituting the third layer include CuI and CuSCN.

Here, when the photoelectric conversion element 100 of the present embodiment is applied to a light sensor or a photovoltaic generation element (solar cell), the photoelectric conversion element 100 is mounted on a semiconductor substrate such as silicon or a glass substrate. In this case, for example, the following device configurations can be used.
(1) a form in which the positive electrode layer 101 having transparency is formed on the uppermost layer most distant from the semiconductor substrate (that is, a configuration in which the (transparent) positive electrode layer 101/the third layer 106/the second layer 105/the first layer 104/the negative electrode layer 102/(Si) substrate are laminated in that order from the uppermost layer on the light incidence side)
(2) a form in which the negative electrode layer 102 having transparency is formed adjacent to the glass substrate (that is, a configuration in which the (glass) substrate/the negative electrode layer 102/the first layer 104/the second layer 105/the third layer 106/the positive electrode layer 101 are laminated in that order from the uppermost layer on the light incidence side)
(3) a form in which the negative electrode layer 102 having transparency is formed on the uppermost layer most distant from the semiconductor substrate (that is, a configuration in which the (transparent) negative electrode layer 102/the first layer 104/the second layer 105/the third layer 106/the positive electrode layer 101/(Si) substrate are laminated in that order from the uppermost layer on the light incidence side)

### (Energy band structure)

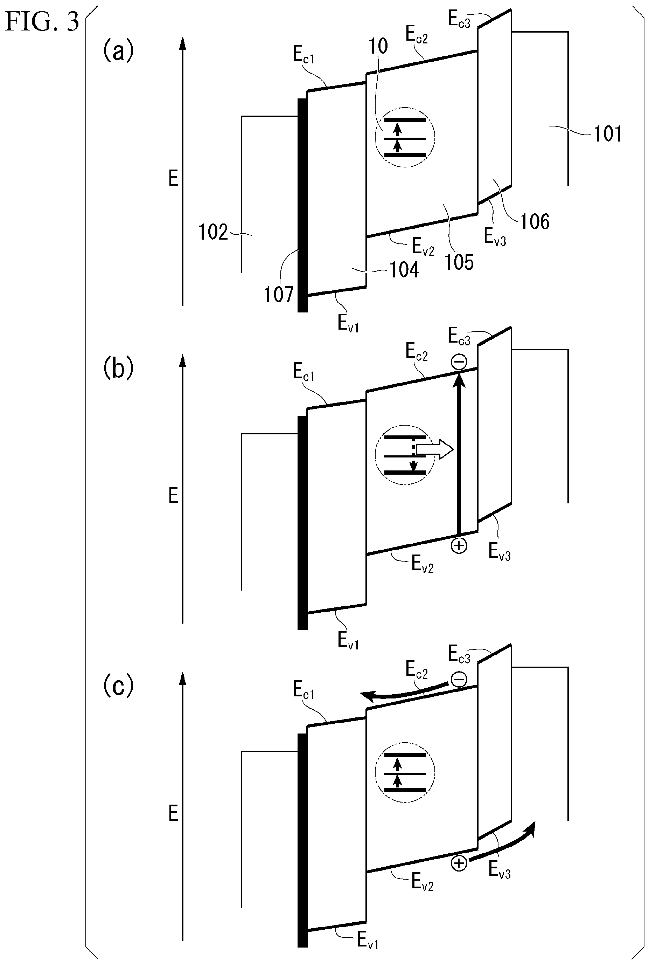

Figs. 3(a) to 3(c) show structures of energy bands of respective layers during an operation of the photoelectric conversion element 100 according to the present embodiment.

When light is not emitted, the energy level of the third layer 106 in the conduction band is higher than the Fermi level of the positive electrode layer 101 on the side of the positive electrode layer 101, and as shown in Fig. 3(a), a current from the positive electrode layer 101 to the negative electrode layer 102 is blocked.

When light having a wavelength of 800 nm or more is emitted to the photoelectric conversion element, the core (the inorganic nanoparticle 11) of the core-shell particle 10 constituting the second layer 105 absorbs the light and converts the wavelength into a visible light wavelength. The perovskite structure absorbs the light whose wavelength is converted (Fig. 3(b)). Here, in Fig. 3(b), the broken line arrow and the solid line arrow in the core-shell particle 10 indicate the same degree of energy. The perovskite structure generates electrons e and holes h by absorbing light, and the electrons e transition to the conduction band E_{c1} and the holes h transition to the valence band Eᵥ₃ (Fig. 3(c)).

In the above example, a case in which the first layer 104a is a porous film has been exemplified, but as in a first layer 104b in Fig. 2(b), the first layer may be formed in a uniform film.

### (Modified examples of photoelectric conversion element)

Next, modified examples of the photoelectric conversion element will be described. Hereinafter, similar components will be distinguished by different letters appended to the same sign. However, the description of the same components will be omitted. In addition, among similar components, when components have substantially the same functional configuration as the components that have described, the description of the components will be omitted.

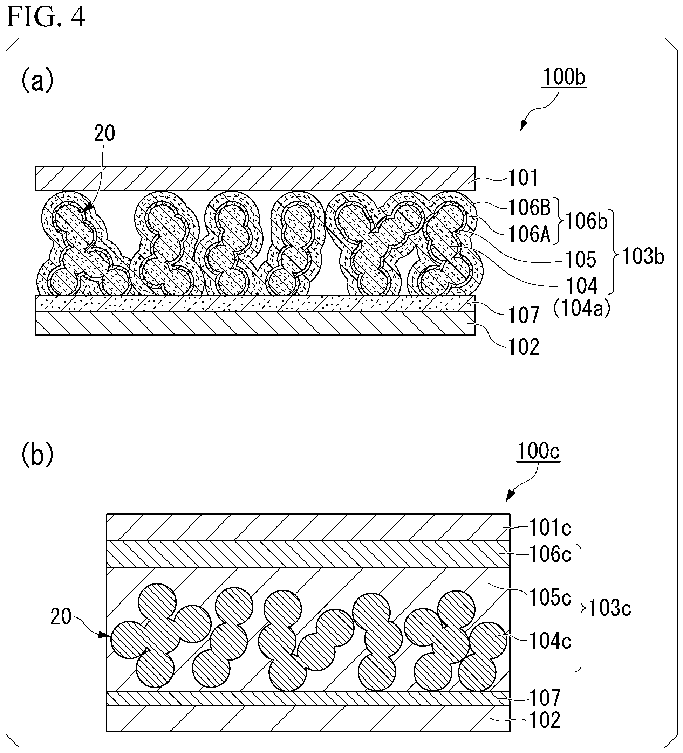

Fig. 4(a) is a cross-sectional view of a photoelectric conversion element 100b including the core-shell particle 10. The photoelectric conversion element 100b is mainly composed of the positive electrode layer (positive electrode member) 101, the negative electrode layer (negative electrode member) 102, and a photoelectric conversion layer 103b interposed therebetween. Here, Fig. 4(a) is a cross-sectional view showing a detailed structure, and in some case, it may be simply illustrated as shown in Fig. 4(b). Incidentally, in Fig. 4(b), within a configuration of a photoelectric conversion layer 103c, a second layer 105c and a third layer 106c are shown as layers that face the negative electrode layer 102 (and the buffer layer 107) and a positive electrode layer 101c. A simple illustration of the photoelectric conversion layer 103b in Fig. 4(a) is the photoelectric conversion layer 103c in Fig. 4(b). In this case, the first layer 104a in Fig. 4(a) corresponds to 104c in Fig. 4(b), and the second layer 105 in Fig. 4(a) corresponds to 105c in Fig. 4(b). The third layer 106b in Fig. 4(a) corresponds to the third layer 106c in Fig. 4(b).

### (Photoelectric conversion layer)

As shown in Fig. 4(a), mainly, the photoelectric conversion layer 103b may be a laminate including the first layer 104a composed of a plurality of particles 20 including an inorganic semiconductor as a main component (that is, inorganic semiconductor particles), or an aggregate thereof or a thin film including the inorganic semiconductor as a main component, the second layer 105 which is formed on the surface of the first layer 104a and is composed of an aggregate or a thin film (composite) including a perovskite structure as a main component, and additionally including the core-shell particle 10, and the third layer 106b composed of a plurality of particles including an organic metal complex as a main component or an aggregate thereof or a thin film including the organic metal complex as a main component. Here, "including an organic metal complex as a main component" means that, in particles or an aggregate thereof, or a thin film, the content of the organic metal complex is more than 50 volume%. The content is preferably more than 90 volume%, and more preferably, the main component is composed of a substantially inorganic semiconductor. That is, the photoelectric conversion layer 103b may have a configuration in which the positive electrode layer 101, the third layer 106b, the second layer 105, the first layer 104, and the negative electrode layer 102 are arranged in that order, and at least a current path is formed from the positive electrode layer 101 to the negative electrode layer 102. A larger number of current paths to be formed is more preferable, but adjacent current paths may or may not be electrically connected to each other.

In addition, materials and compositions of the three layers 104 to 106b are determined such that the energy levels in the conduction band (LUMO, excited state) increase in order of the first layer 104, the second layer 105, and the third layer 106b, and the energy level of the second layer in a valence band (HOMO, ground state) is higher than the energy level of the third layer 106b in the valence band. In the conduction band, the energy level of the second layer 105 is higher than the energy level of the first layer 104, and the energy level of the third layer 106b is higher than the energy level of the second layer 105. For example, in the first layer 104, the energy level in the valence band can be set to -8 eV or higher, and the energy level in the conduction band can be set to -4 eV or lower. In this case, in the second layer 105, the energy level in the valence band can be set to -5.5 eV or higher, and the energy level in the conduction band can be set to -3 eV or lower. In addition, in the third layer 106b, preferably, the energy level in the valence band is -6 eV or higher, and the energy level in the conduction band is -2 eV or lower.

The third layer 106b may be a thin film that covers a surface (exposed surface) of a molecule of the perovskite structure contained in the second layer within a photoelectric conversion element precursor including the first layer 104 and the second layer 105. A molecule of the organic metal complex constituting the third layer 106b is obtained by forming a coordinate bond between the inorganic transition metal and the organic ligand. Here, 106A indicates an inorganic transition metal ion of the third layer 106b, and 106B indicates an organic ligand of the third layer 106b.

In the organic metal complex, inorganic transition metal ions may be localized in a film shape on the side of the second layer so that they are directly bonded to the perovskite structure of the second layer 105. On the other hand, the organic ligand may be localized in a film shape on the side opposite to the second layer (on the side of the positive electrode). Then, in order to realize amplification of a photocurrent to be described below, molecules of the organic metal complex may be bonded to molecules of the perovskite structure such that the organic ligand and inorganic transition metal ions are arranged in that order on the current path from the side of the positive electrode layer 101 to the side of the second layer 105. That is, this structure is divided into a layer formed of inorganic transition metal ions and a layer formed of organic ligand ions. Here, a boundary between the two layers can be confirmed using, for example, a transmission electron microscope (TEM).

Examples of inorganic transition metal ions here include Eu³⁺, Cr³⁺, and the like where the reduction potential is LUMO, and Ru²⁺, Fe²⁺, Mn²⁺, Co²⁺, and the like where the oxidation potential is HOMO. In addition, examples of organic ligands here include a ligand of a general metal complex, for example, (i) an organic compound having a carboxyl group, a nitro group, a sulfo group, a phosphate group, a hydroxy group, an oxo group or an amino group; (ii) an ethylenediamine derivative; (iii) a ring heteroatom-containing organic ligand such as a terpyridine derivative, a phenanthroline derivative, or a bipyridine derivative; and (iv) an acetylacetonato-based organic ligand (here, "acetylacetonato-based organic ligand" refers to an organic ligand that can form a coordinate bond with many transition metal ions through two oxygen atoms (for example, while forming a six-membered ring)) such as a catechol derivative, a quinone derivative, a naphthoic acid derivative, or an acetylacetonato derivative (specifically for example, acetylacetone). Here, the terpyridine derivative has a composition represented by the following formula (1).

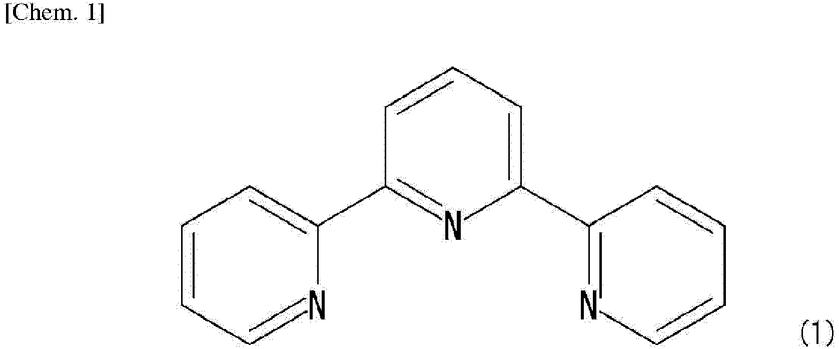

The thickness of the third layer 106b is preferably, for example, about 1 nm or more and 10 nm or less. If the third layer 106b is thicker than 10 nm, the energy barrier becomes too thick, a sufficient tunneling probability cannot be obtained, and amplification of a photocurrent in the photoelectric conversion layer 103b is hindered. In addition, if the third layer 106b is thinner than 1 nm, light is not emitted, a tunneling current flows even when the band is not bent, and thus the light detection function of the photoelectric conversion layer 103b becomes meaningless.

Here, when a light-receiving member for a photoelectric conversion element formed by laminating the second layer 105 composed of a composite of the core-shell particle 10 and the perovskite structure, and the third layer 106b composed of an aggregate or thin film including an organic metal complex as a main component is provided between the hole transport layer and the electron transport layer, it can be utilized as the photoelectric conversion element.

### (Energy band structure)

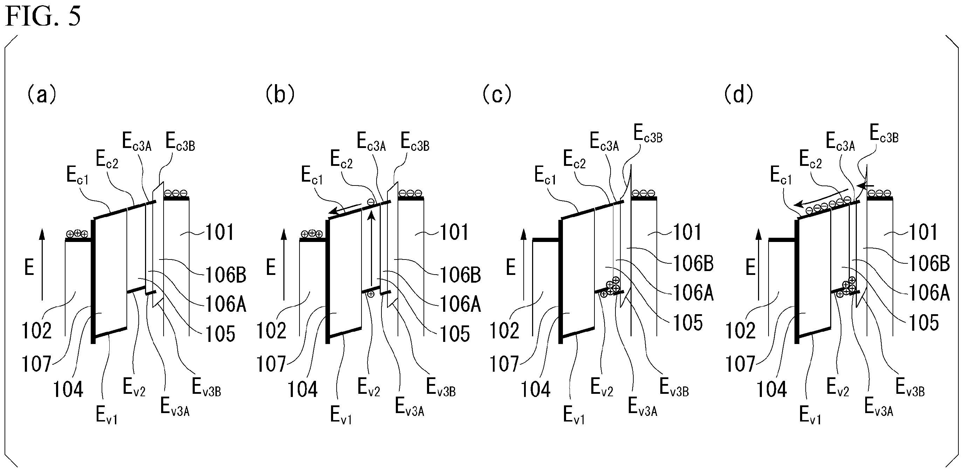

Figs. 5(a) to 5(d) show structures of energy bands of respective layers during an operation of the photoelectric conversion element 100 according to the present embodiment. Here, 106A indicates an inorganic transition metal ion of the third layer 106b, and 106B indicates an organic ligand of the third layer 106b.

When light is not emitted, the energy level of the third layer 106b in the conduction band is higher than the Fermi level of the positive electrode layer 101 on the side of the positive electrode layer 101, and as shown in Fig. 5(a), a current from the positive electrode layer 101 to the negative electrode layer 102 is blocked.

When light L₁ having a wavelength of 800 nm or more is emitted to the photoelectric conversion element, the core (the inorganic nanoparticle 11) of the core-shell particle 10 constituting the second layer 105 absorbs the light and converts the wavelength into a visible light wavelength. The perovskite structure absorbs the light whose wavelength is converted, and generates electrons e and holes h, and the electrons e transition to the conduction band E_{c2} and the holes h transition to the valence band Eᵥ₂ (Fig. 5(b)).

In this case, since the energy levels E_{c1}, E_{c2}, and E_{c3} of the first layer 104a, the second layer 105, and the third layer 106b in the conduction bands have a relationship of E_{c3}>E_{c2}>E_{c1}, the electrons e that are generated in the second layer 105 and transitioned to the conduction band of the same layer transition to the conduction band E_{c1} of the first layer 104a which is in a lower energy state.

On the other hand, since the energy levels Eᵥ₁, Eᵥ₂, and Eᵥ₃ of the first layer 104a, the second layer 105, and the third layer 106b in the valence bands have relationships of Eᵥ₂>Eᵥ₁ layer, and Eᵥ₂>Eᵥ₃, as shown in Fig. 5(c), the holes that are generated in the second layer and transitioned to the valence band are trapped in the valence band of the second layer which is in an energy state higher than (for the holes, lower than) those of the first layer and the third layer.

Due to the effect (positive potential) of the holes that are trapped and distributed in a concentrated manner, in the vicinity of the valence band of the second layer, the potential energy of the electrons decreases, and the energy level in the conduction band decreases. Since the energy level in the conduction band significantly decreases toward the second layer in which the holes are trapped, the energy level of the third layer in the conduction band decreases more significantly on the side of the second layer and has a shape in which the side of the positive electrode layer is sharp. Accordingly, due to the electrons present in the positive electrode layer 101, the energy barrier of the third layer becomes thinner and as shown in Fig. 5(d), the side of the negative electrode layer can be tunneled. That is, when light is emitted to the photoelectric conversion element, a large number of electrons (electrons to which light is not emitted) on the side of the positive electrode that are blocked by the energy barrier of the third layer tunnel (are transmitted) through the thin energy barrier, and they can flow to the side of the negative electrode. Therefore, the photoelectric conversion element of this modified example can realize significant amplification of a current directly generated with light emitted.

### (Method for producing core-shell particles)

Next, a method for producing the core-shell particle 10 of the present disclosure will be described. The method for producing the core-shell particle 10 of the present disclosure includes an inorganic nanoparticle synthesizing step and a coating layer forming step.

### "Inorganic nanoparticle synthesizing step"

In the inorganic nanoparticle synthesizing step, the inorganic nanoparticles 11 are synthesized. A method for synthesizing the inorganic nanoparticles 11 are not particularly limited, and examples thereof include a precipitation method and a hydrothermal synthesis method. Specifically, a trifluoroacetate is synthesized using Ln (lanthanoid) oxides, for example, Er₂O₃, Tm₂O₃, Ho₂O₃, YbsOs, or Ln halides, for example, ErCl₃, ErF₃, TmCl₃, TmF₃, HoCl₃, or HoF₃, as a main raw material. In addition, the reaction is performed using sodium trifluoroacetate and chain organic molecules under high temperature conditions (100 to 400°C) in a N₂ or Ar atmosphere. The solution after the reaction is cooled, as necessary, an organic solvent such as ethanol is added thereto, centrifuging is then performed, the inorganic nanoparticles 11 are separated, and thus the inorganic nanoparticles 11 are obtained.

### "Coating layer forming step"

Next, in the coating layer forming step, the coating layer 12 is formed on the inorganic nanoparticles 11 obtained in the inorganic nanoparticle synthesizing step. A method for forming the coating layer 12 is not particularly limited, and examples thereof include a precipitation method and a hydrothermal synthesis method. Specifically for example, the inorganic nanoparticles 11 are reacted with a solution containing cesium oleate synthesized from cesium carbonate and lead halide (PbX₂). The temperature is 120 to 200°C, and the atmosphere is a nitrogen atmosphere. The solution after the reaction is cooled, and fine particles are separated by centrifuging. Core-shell particles are obtained by firing (for example, at 200°C to 300°C) the fine particles after separation.

### (Method for producing photoelectric conversion element)

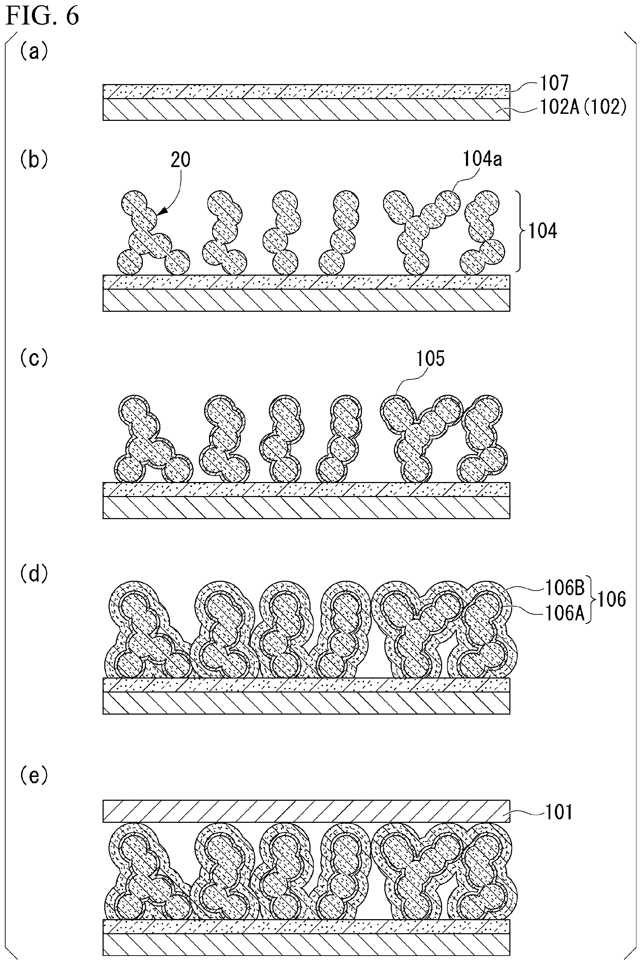

Figs. 6(a) to 6(e) show cross-sectional views of an object to be processed in a process of producing the photoelectric conversion element 100. The photoelectric conversion element 100 can be produced mainly according to the following procedure.

First, as shown in Fig. 6(a), a substrate on which the negative electrode layer 102 is provided for forming the photoelectric conversion layer 103 is prepared. As the negative electrode layer 102 on the substrate, an electrode member that functions as a negative electrode layer and has transparent conductivity is used. Here, a case in which the buffer layer 107 is formed on one surface of the negative electrode layer 102 is exemplified, but the buffer layer 107 may not be formed. Here, the buffer layer 107 functions as an electron transport layer or a hole blocking layer. The buffer layer 107 can be formed by applying a material solution to the negative electrode layer 102 using a spin coating method or the like and heating (drying) it. This heating may be performed, for example, at about 120 to 450°C for about 10 to 60 minutes. Conditions (an application time, etc.) of the material application may be adjusted such that the thickness of the buffer layer 107 is, for example, about 1 to 100 nm.

Next, as shown in Fig. 6(b), the first layer 104a composed of a plurality of particles 20 including an inorganic semiconductor as a main component (that is, inorganic semiconductor particles) is formed on one surface side of the negative electrode layer 102 (if the buffer layer 107 is included, with the buffer layer 107 interposed therebetween). As the buffer layer 107, the first layer 104a can also be formed by applying a material solution and heating it. This heating may be performed, for example, at about 120 to 450°C for about 10 to 60 minutes. Conditions (an application time, etc.) of the material application may be adjusted such that the thickness of the first layer 104a is, for example, about 10 to 1,000 nm, and preferably about 50 to 500 nm.

Next, as shown in Fig. 6(c), a solution containing a raw material of a perovskite structure as a main component and the core-shell particle 10 may be applied to the surface of the inorganic semiconductor particle 20 using a spin coating method, a dip method or the like, and heated to form the second layer 105. This heating may be performed, for example, at about 40 to 100°C for about 5 to 10 minutes. The thickness of the second layer 105 is adjusted according to material application conditions (an application time, etc.). When a liquid material is used, a thin film can be formed under the condition in which the environmental load is smaller compared to when a solid inorganic semiconductor such as silicon is used.

Next, as shown in Fig. 6(d), the third layer 106 may be formed on the second layer 105. More specifically, a material including a p-type organic semiconductor or an inorganic semiconductor as a main component is deposited or a solution containing the material is applied on the second layer 105 using a spin coating method, a dip method or the like, and thus the third layer 106 may be formed. Actually, when the second layer 105 is formed, substantially all the gaps between the inorganic semiconductor particles 20 of the first layer 104a are buried. Therefore, the third layer 106 can be formed in a film shape on an exposed portion of the surface of the second layer 105 mainly on the side of the positive electrode layer 101 (the side opposite to the negative electrode layer 102).

When the organic metal complex is formed as the third layer (that is, when the third layer 106b is formed), application and heating of the solution here may be performed in two steps. That is, in the first step, a solution containing an inorganic transition metal such as europium may be applied and heated, and subsequently, in the second step, a solution containing an organic ligand such as terpyridine may be applied and heated. In this manner, as a result of performing formation of the third layer 106b in two steps, the third layer 106b has a structure in which the layer 106A formed of an inorganic transition metal and the layer 106B formed of an organic ligand are laminated in order from the side of the second layer 105.

Finally, as shown in Fig. 6(e), when the electrode member (positive electrode layer) 101 that functions as a positive electrode and has conductivity is formed on the third layer 106, the photoelectric conversion element 100 of the present embodiment can be obtained.

In the method for producing the photoelectric conversion element, a case in which the first layer 104a formed of a porous material is used has been described, but the layered first layer 104b can also be produced by the same method as described above. The first layer 104b can be formed by a known method such as deposition.

As described above, the core-shell particle 10 of the present embodiment has a configuration in which the inorganic nanoparticle 11 as a core converts the absorbed long-wavelength light such as near infrared light into short-wavelength light such as visible light and ultraviolet light, and the converted light is re-absorbed by the inorganic perovskite type substance of the coating layer 12 that becomes the shell and converted into power. Therefore, according to the core-shell particle 10 of the present embodiment, it is possible to generate photoelectric conversion or an electromotive force from long-wavelength light, which was difficult in the past.

In addition, when the core-shell particle 10 of the present embodiment has a core-shell structure, it is possible to reliably and efficiently perform energy transfer between close inorganic nanoparticles and the inorganic perovskite type substance, and it is possible to reduce energy loss. Therefore, even if light absorbed by the core is weak light, it is possible to realize excellent photosensitization characteristics.

### [Examples]

Hereinafter, the effects of the present invention will become more apparent from examples. However, the present invention is not limited to the following examples, but can be appropriately changed and implemented within ranges without changing the gist of the invention.

### (Production of core-shell particles)

Core-shell particles were produced according to the method for producing core-shell particle described above, specifically, under the following conditions.

### (Core-shell particles 1)

Inorganic nanoparticles as cores of core-shell particles were synthesized by a precipitation method. Specifically, 1 mmol of Er oxide (Er₂O₃) was dissolved in 5 mL of trifluoroacetic acid and 5 mL of water, and heated and stirred at 80°C under a reduced pressure. 2.5 mmol of sodium trifluoroacetate (NaCOOCF₃) was added to the powder obtained by evaporation and drying, and the mixture was dissolved in 15 mL of oleylamine. After the mixture was stirred at 100°C for 30 minutes under a reduced pressure, nitrogen was introduced into the system, and stirred at 330°C for 1 hour. After cooling was performed to 80°C, 20 mL of ethanol was added, and NaErF₄ nanoparticles were separated by a centrifugation method.

0.81 g of cesium carbonate (CsCO₃) was dissolved in 2.5 mL of oleic acid and 40 mL of octadecene, and stirred at 120°C for 1 hour under a nitrogen atmosphere. In addition, stirring was performed at 160°C for 30 minutes to obtain cesium oleate.

A coating layer was formed on the synthesized NaErF₄ nanoparticles by a precipitation method. Specifically, 0.4 mmol of PbBr₂ and NaErF₄ nanoparticles were dispersed in 10 mL of octadecene, and the mixture was stirred at 120°C for 1 hour under a nitrogen atmosphere. In addition, 1 mL of oleic acid and oleylamine were added. After the temperature was raised to 180 to 190°C, 0.85 mL of cesium oleate was added, and the mixture was stirred for 1 hour. After cooling, the nanoparticles were separated by a centrifugation method and fired at 200°C for 30 minutes to obtain a one-layer core-shell particle (a particle size of 25 nm). The particle size of the core-shell particle was obtained from an SEM image obtained from SEM observation.

### (Core-shell particles 2)

0.4 mmol of PbBr₂ and the one-layer core-shell particles obtained above were dispersed in 10 mL of octadecene, and stirred at 120°C for 1 hour under a nitrogen atmosphere. In addition, 1 mL of oleic acid and oleylamine were added. After the temperature was raised to 180 to 190°C, 0.85 mL of cesium oleate was added, and the mixture was stirred for 1 hour. After cooling, the nanoparticles were separated by a centrifugation method and fired at 200°C for 30 minutes to obtain two-layer core-shell particles (a particle size of 30 nm).

### (Nanoparticles 1)

Inorganic nanoparticles were synthesized by a precipitation method. Specifically, 1 mmol of Er oxide (Er₂O₃) was dissolved in 5 mL of trifluoroacetic acid and 5 mL of water, and heated and stirred at 80°C under a reduced pressure. 2.5 mmol of sodium trifluoroacetate (NaCOOCF₃) was added to the powder obtained by evaporation and drying, and the mixture was dissolved in 15 mL of oleylamine. After the mixture was stirred at 100°C for 30 minutes under a reduced pressure, nitrogen was introduced into the system, and stirred at 330°C for 1 hour. After cooling was performed to 80°C, 20 mL of ethanol was added, and NaErF₄ nanoparticles (a particle size of 20 nm) were separated by a centrifugation method.

Photoelectric conversion elements were produced according to the method for producing a photoelectric conversion element described above, specifically, under the following conditions.

### (Example 1)

As a member provided on a substrate and serving as a negative electrode layer, a member substantially formed of an antimony-doped indium oxide (ATO) was prepared. One surface of the member was spin-coated with 200 µl of an ethanol (C₂H₅OH) liquid containing europium chloride hydrate (EuCl₃·6H₂O) at a concentration of 10 mM at a rotational speed of 3,000 rpm. Subsequently, the spin-coated mixed solution was heated at 120°C for 10 minutes and heated at 450°C for 1 hour in that order, and a buffer layer substantially formed of europium oxide (Eu₂O₃) was formed.

Next, the buffer layer was spin-coated with 120 µl of a mixed solution containing a titanium oxide (TiO₂), a paste (PST18NR, commercially available from JGC Catalysts and Chemicals Ltd.) and ethanol at a weight ratio of 1:3.5 at a rotational speed of 6,000 rpm. Subsequently, the spin-coated mixed solution was heated at 120°C for 10 minutes and heated at 450°C for 1 hour in that order, and a first layer (porous film) composed of a plurality of particles substantially formed of titanium oxide was formed.

Next, the porous film of the first layer was spin-coated with 100 µl of a mixed solution of dimethylformamide (DMF) and dimethylsulfoxide (DMSO) at a concentration of 0.5 M or less, which containing 1 M of lead iodide (PbI₂), 1 M of cesium iodide (CsI) and 8 wt% concentration (w%) of the core-shell particles 1, at a rotational speed of 5000 rpm. Subsequently, the spin-coated mixed solution was heated at 185°C for 15 minutes, and a second layer containing the core-shell particles of the present invention was formed.

Next, the second layer was spin-coated with 100 µl of an isopropyl alcohol (IPA) liquid containing europium chloride (EuCl₃) at a concentration of 5 mM at a rotational speed of 5,000 rpm. Subsequently, the spin-coated mixed solution was heated at 100°C for 15 minutes, and a layer substantially formed of europium was formed.

Next, the layer including europium as a main component was left in 200 µl of an isopropyl alcohol (IPA) liquid containing terpyridine (2,2': 6',2"-terpyridine) at a concentration of 20 mM for 30 seconds and then spin-coated at a rotational speed of 3,000 rpm. Subsequently, the spin-coated mixed solution was heated at 100°C for 15 minutes and a layer substantially formed of terpyridine was formed.

Finally, a positive electrode layer (Ag) was formed (deposited) to be in contact with the third layer and on the side opposite to the negative electrode layer with a laminate including the first layer, the second layer, and the third layer therebetween, and thereby a photoelectric conversion element of Example 1 was produced.

### (Example 2)

A photoelectric conversion element was produced under the same conditions as in Example 1 except that core-shell particles 2 were used in place of the core-shell particles 1.

### (Example 3)

A photoelectric conversion element was produced under the same conditions as in Example 1 except that, as the third layer, a layer formed of BCP (a film thickness of 30 nm) was formed by a vacuum deposition method.

### (Example 4)

A photoelectric conversion element was produced under the same conditions as in Example 1 except that, as the third layer, a layer substantially formed of Spiro-OMeTAD (a film thickness of 100 nm) was formed.

### (Comparative Example 1)

A photoelectric conversion element was produced under the same conditions as in Example 1 except that nanoparticles 1 were used in place of the core-shell particles 1.

### (Light emission spectrum of core-shell particles)

The spectrums when near infrared light having a wavelength of 980 nm was emitted to respective particles of the core-shell particles 1 and 2 and the nanoparticles 1 were measured by an absolute PL quantum yield measurement device (commercially available from Hamamatsu Photonics K.K.).

### (Light absorption spectrum of core-shell particles)

The light absorption spectrum of the core-shell particle 2 was measured by an absolute PL quantum yield measurement device (commercially available from Hamamatsu Photonics K.K.).

### (SEM observation)

The cross section of the photoelectric conversion element of Example 2 was observed using a scanning electron microscope (commercially available from Hitachi High-Tech Corporation) at a magnification of 150,000, and an SEM image was obtained.

### (Response characteristics of photocurrent)

For Example 2, the optical response characteristics were measured. The voltage applied between the positive electrode layer and the negative electrode layer of the photoelectric conversion element was -0.5 V. The wavelength and irradiance of light emitted to the photoelectric conversion element were 808 nm and 10 mW/cm², respectively.

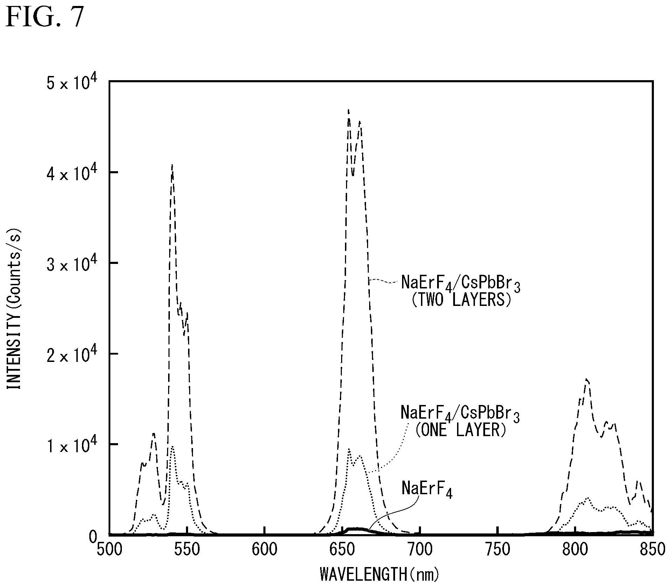

Fig. 7 is a graph showing spectrums of light whose wavelength is converted when near infrared light having a wavelength of 980 nm was emitted to the photoelectric conversion elements of the core-shell particles 1 and 2. The horizontal axis of the graph represents wavelength (nm), and the vertical axis of the graph represents intensity (Counts/s). Since peaks were shown at three wavelengths (around 550 nm, around 650 nm, and around 800 nm), it can be understood that emitted near infrared light was converted into these three light beams. The broken line indicates the spectrum when the coating layer CsPbBr₃ was two layers (the core-shell particles 2), and the dotted line indicates the spectrum when the coating layer CsPbBr₃ was one layer (the core-shell particles 1). Here, for comparison, the spectrum of NaErF4 (solid line) alone of the nanoparticles 1 is shown. The light emission intensity was significantly increased by the coating layer CsPbBr₃, and further increased by increasing the thickness of the layer. These results show that light emission was deactivated by thermal vibration of chain organic molecules in the case of only inorganic nanoparticles, but deactivation of the coating layer CsPbBr₃ was minimized. Here, the position of the peak can be adjusted by changing the material, the shape, the size and the like of the core-shell particles.

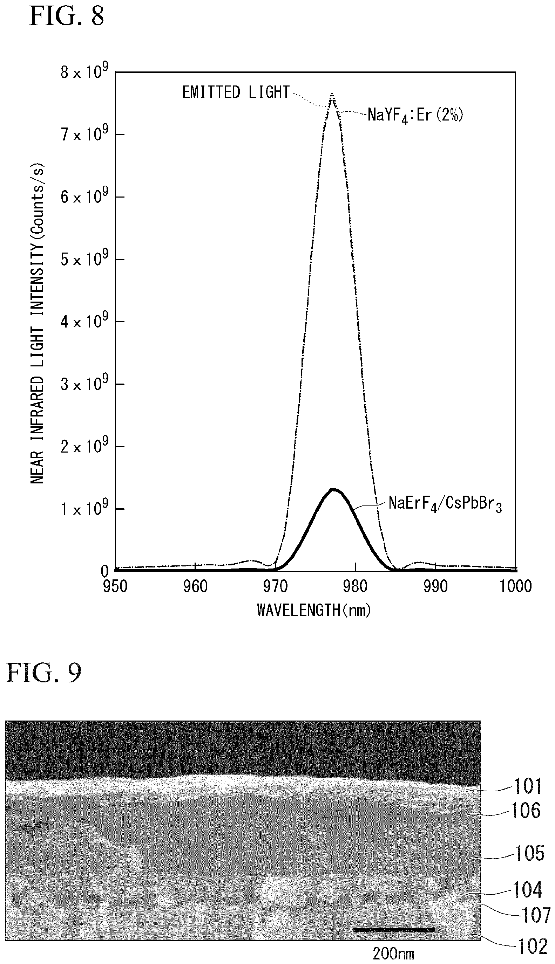

Fig. 8 is a graph showing changes in an absorption rate due to a difference in a structure of core-shell particles in the second layer. The horizontal axis of the graph represents wavelength (nm), and the vertical axis of the graph represents intensity (Counts/s). The solid line indicates the results of the core-shell particle 2. For comparison, an absorption rate (broken line) of NaYF₄ nanoparticles containing 2% of Er ions was also shown. Since the core-shell particle 2 contained an amount of Er ions of 100%, the intensity of emitted near infrared light was about one-seventh that of general up-conversion nanoparticles (using 2% of Er). It is considered that the near infrared light corresponding to the lowered intensity was absorbed by the core (inorganic nanoparticles) of the core-shell particles.

Fig. 9 is an SEM image of the cross section of the photoelectric conversion element produced as an example. It can be understood that a structure in which layers including a first layer, a second layer, and a third layer were laminated in that order was formed, and a current path connecting Ag-ATO electrodes was formed.

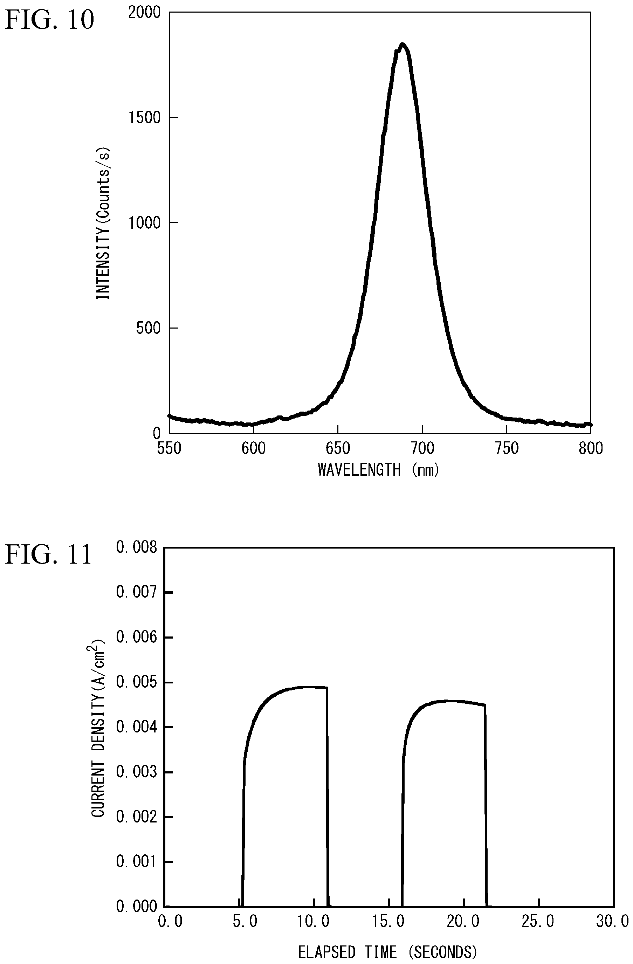

Fig. 10 is a graph showing the spectrum of light whose wavelength was converted when near infrared light having a wavelength of 980 nm was emitted to the second layer of the photoelectric conversion element of Example 2. The horizontal axis of the graph represents wavelength (nm), and the vertical axis of the graph represents intensity (Counts/s). Originally, the perovskite layer (here, CsPbI₃) could not absorb light of 800 nm or more, but in the second layer of Example 2, light of 980 nm could be converted into visible light shown in Fig. 7 due to the inclusion of the core-shell particle 2. Since emission of light derived from CsPbI₃ was observed near 700 nm, this indicates that visible light whose wavelength was converted by the core-shell particle 2 was absorbed by CsPbI₃.

Fig. 11 is a graph showing the response speed of the photocurrent obtained when light was emitted to the photoelectric conversion element of Example 2 at a predetermined timing. The horizontal axis of the graph represents elapsed time (s), and the vertical axis of the graph represents photocurrent (A/cm²). The photocurrent shows an instantaneous rise and fall according to on/off of the voltage, and it can be understood that a sufficient response speed could be realized. The photoelectric conversion efficiency was 75%, and the sensitivity was 0.49 A/W.

### [Reference Signs List]

10 Core-shell particle
11 Inorganic nanoparticles
11a Particle size of inorganic nanoparticle
12 Coating layer
12a Thickness of coating layer
100 Photoelectric conversion element
101 Positive electrode layer
102 Negative electrode layer
103 Photoelectric conversion layer
104 First layer
105 Second layer
106 Third layer
107 Buffer layer

## Claims

1. A core-shell particle which includes a core-shell structure comprising:
an inorganic nanoparticle having a light wavelength conversion ability; and
a coating layer formed on a surface of the inorganic nanoparticle, and formed of an inorganic perovskite type substance.

2. The core-shell particle according to claim 1,
wherein the inorganic nanoparticle includes a rare earth element.

3. A composite that is an aggregate or a thin film comprising a perovskite structure as a main component, and additionally included the core-shell particle according to claim 1 or 2.

4. A light-receiving member for a photoelectric conversion element comprising a layer composed of the composite according to claim 3 and a layer composed of an aggregate or a thin film including an organic or an inorganic semiconductor (including a metal complex) as a main component that are laminated.

5. A photoelectric conversion element comprising the light-receiving member for a photoelectric conversion element according to claim 4 between a hole transport layer and an electron transport layer.

6. A photoelectric conversion element comprising a first layer, a second layer, and a third layer that are laminated in that order,
wherein the first layer is composed of a plurality of particles including an inorganic semiconductor as a main component, or an aggregate thereof or a thin film including the inorganic semiconductor as a main component,
the second layer is formed on a surface of the first layer and is composed of the composite according to claim 3, and
the third layer is composed of a plurality of particles including an organic or an inorganic semiconductor (including a metal complex) as a main component or an aggregate thereof, or a thin film including the organic or the inorganic semiconductor (including a metal complex) as a main component,
in a conduction band, an energy level of the second layer is higher than an energy level of the first layer, and an energy level of the third layer is higher than the energy level of the second layer.

7. The photoelectric conversion element according to claim 6,
wherein the third layer includes an organic metal complex as a main component, and the energy level of the second layer band is higher than the energy level of the third layer in a valence.
